# EUROPEAN PATENT APPLICATION

(11) **EP 4 596 111 A1**
(43) Date of publication of application: **06.08.2025**
(21) Application number: 24216425.9
(22) Date of filing: 29.11.2024
(51) Int. Cl.: B05B 13/02, C25D 17/08

(54) **CONNECTING STRUCTURE, SUPPORTING FRAME, RIVETING PART, AND METHOD FOR SURFACE TREATMENT OF SUPPORTING FRAME**

(30) Priority: 30.01.2024 CN 202410129206
(71) Applicant: Capatronics Electronics (Kunshan) Co., Ltd., Suzhou, Jiangsu 215300 (CN)
(72) Inventor: Wang, Chuanbao, Shou County, Anhui Province, 232200 (CN); Wang, Zhiwei, Kunshan City, Jiangsu Province, 215332 (CN)
(74) Representative: Cleanthous, Marinos

(57) **Abstract**

The present invention discloses a method for surface treatment of a supporting frame. The supporting frame includes a main plate body and a bracket body which are rotatably connected. The main plate body and the bracket body are connected through a connecting structure. The main plate body is assembled with the bracket body. The main plate body and the bracket body are respectively provided with a main plate connecting part and a bracket connecting part. Surface treatment is performed on the assembled supporting frame. An included angle between the main plate body and the bracket body during surface treatment is a first included angle. After treatment, when the bracket body rotates around the main plate body to a second included angle, a surface treatment agent is distributed in any area of working surfaces of the main plate connecting part and the bracket connecting part. The first included angle is different from the second included angle. The present invention can complete the surface treatment of the supporting frame in one time, reduce the production cost of the enterprise, and improve the processing efficiency of the supporting frame.

## Description

### Technical Field

The present invention relates to the technical field of network connection equipment, and in particular to a connecting structure, a supporting frame, a riveting part, and a method for surface treatment of a supporting frame.

### Background

A supporting frame, i.e., a commonly used cable arranging frame in network connection equipment, is a device used for standardizing network cabling, is generally used in network (such as local area network) mounting, is used in conjunction with a switch, and is mounted in a cabinet or a frame. The supporting frame is used for organizing cables at a back end of a distribution frame, making the routing of the cables at the back end more regular, neat, and aesthetically pleasing, and facilitating the maintenance of network equipment and cables.

An existing foldable supporting frame structure is formed by connecting one supporting frame to each side of a main plate through rivets. There are two common methods for surface treatment of foldable supporting frames. One is to spray-coat or electroplate the main plate and the supporting frame separately, and then hinge them together after spray-coating or electroplating. However, this method of spray-coating or electroplating in multiple times results in low surface processing efficiency of the foldable supporting frame, and the use of rivets also makes the processing cost of the foldable supporting frame high. The other method is to firstly assemble the main plate and the supporting frame, and then perform overall spray-coating or electroplating. However, the existing foldable supporting frame cannot be spray-coated or electroplated in one time after assembly. The angle of the supporting frame needs to be adjusted through rotation to ensure that the visible surface of the entire supporting frame can be completely spray-coated or electroplated. This method also leads to low surface treatment efficiency of the supporting frame and inevitable use of rivets, resulting in high overall processing cost.

Therefore, it is necessary to provide a connecting structure, a supporting frame, a riveting part, and a method for surface treatment of a supporting frame.

### SUMMARY

In order to overcome the disadvantages, the purpose of the present invention is to provide a connecting structure, a supporting frame, a riveting part and a method for surface treatment of a supporting frame, which can complete the surface treatment of the supporting frame in one time, reduce the production cost of the enterprise, and improve the processing efficiency of the supporting frame.

In order to achieve the above purpose, the present invention adopts the following technical solution: a method for surface treatment of a supporting frame, the supporting frame including a main plate body and a bracket body which are rotatably connected, the main plate body and the bracket body being connected through a connecting structure, wherein the method includes: assembling the main plate body with the bracket body, the main plate body and the bracket body being respectively provided with a main plate connecting part and a bracket connecting part;
performing surface treatment on the assembled supporting frame, an included angle between the main plate body and the bracket body during surface treatment being a first included angle,
after treatment, when the bracket body rotates around the main plate body to a second included angle, a surface treatment agent being distributed in any area of working surfaces of the main plate connecting part and the bracket connecting part, the first included angle being different from the second included angle.

Further, the surface treatment of the supporting frame is spray-coating, electroplating, or paint baking. It includes, but not limited to, the three methods, i.e., spray-coating, electroplating, and paint baking mentioned above, as long as it can distribute the surface treatment agent onto the surface of the supporting frame. In case of spray-coating, powder spray-coating may be adopted. In case of electroplating, the supporting frame may be placed in an electroplating tank containing electroplating solution.

A connecting structure for achieving rotatable connection between a first part and a second part, wherein the first part is provided with a first connecting part,
the second part is provided with a second connecting part,
a circle where a movement trajectory of each point on an edge of the first connecting part is located is the same circle and is a first circle,
a circle where a movement trajectory of each point on an edge of the second connecting part is located is the same circle and is a second circle, and
the first circle and the second circle are concentrically arranged.

In the present invention, by keeping the movement trajectory of each point on the edge of the first connecting part to be on the edge line of the same circle, i.e., the first circle, and keeping the movement trajectory of each point on the edge of the second connecting part to be on the edge line of the same circle, i.e., the second circle, it is ensured that the first connecting part and the second connecting part will never obstruct each other when the first part and the second part rotate. Therefore, it can achieve spray-coating, electroplating or paint baking of the first part and the second part after assembly, and can achieve the effect of dead-corner-free spray-coating, electroplating or paint baking.

Further, the main plate connecting part and the bracket connecting part are concentrically arranged, and outer edges of the main plate connecting part and the bracket connecting part are both semicircular. Two concentrically arranged semicircles allow the bracket body to rotate freely around the riveting part as the circle center, so that the surface treatment agent is distributed on all visible surfaces of the bracket body and the main plate body.

A supporting frame, wherein the first part is a main plate body, the second part is a bracket body, the first connecting part is a main plate connecting part, the second connecting part is a bracket connecting part, and the main plate body and the bracket body are rotatably connected. The main plate body and the bracket body are rotatably connected, thus achieving the foldability of the main plate body and the bracket body, so that when the supporting frame is not in use, the bracket body can be folded on the side of the main plate body, thus effectively reducing nearly 50% of the space occupied during packaging, and reducing the packaging and transportation cost of the enterprise.

Further, the bracket connecting part is fixedly connected to a side of the bracket body through a supporting part, a horizontal plane on the bracket connecting part is connected to the supporting part, and a plane where the bracket connecting part is located is perpendicular to a plane where the bracket body is located.

Further, the supporting part is provided with a clamping protrusion protruding from a surface of the supporting part in a direction towards the main plate body, and the main plate body is provided with a clamping groove for the clamping protrusion to be clamped in when the bracket body presses against the side of the main plate body. By providing the corresponding clamping protrusion and clamping groove, the bracket body is not easily collapsed when the supporting frame is in a working state, thus ensuring the stability of cables hung on the supporting frame in the working state. It should be noted that it is not limited that the clamping protrusion and the clamping groove can only be provided separately on the supporting part and the main plate body. In a case that the clamping groove is provided in the main plate body, providing the clamping protrusion on the supporting part can also achieve the same effect.

Further, the main plate connecting part is located on lower surfaces of two ends of a length direction of the main plate body, and extends towards an outer side of the main plate body.

Further, one of two surfaces of the main plate body in contact with the bracket body is provided with at least one positioning protrusion, and the other is provided with at least one positioning groove for the positioning protrusion to be clamped in.

Further, the bracket body further includes a mounting part, one end of the mounting part away from the supporting part is provided with hooks, and the main plate body is provided with a plurality of fastening structures for mounting cable ties along a length direction of the main plate body. The hooks are used for mounting the entire supporting frame on a matching distribution frame to arrange network cables.

Each fastening structure includes a network cable slot and a T-shaped clamping hook. The T-shaped clamping hook facilitates the clamping of the cable tie, thus improving the convenience in use. When no cable tie is used, the network cable slot can also play a role of storing the network cable.

It should be noted that the size and layout of the fastening structures are not limited, as long as they can meet the quantity and size requirements of network cables.

Further, a side of the main plate body away from a riveting part is provided with at least one groove along a length direction of the main plate body, and the depth of the groove is greater than the thickness of the main plate body. By providing the groove, the overall stress strength of the supporting frame can be enhanced, and the service life of the supporting frame can be improved.

Further the diameter of the main plate connecting part is equivalent to the diameter of the bracket connecting part. The bracket body is connected to the main plate body through the connecting structure of the supporting frame. Only when the diameter of the main plate connecting part and the bracket connecting part is the same, can all visible surfaces of the main plate body and the bracket body be treated in one time, so that all visible surfaces are distributed with the surface treatment agent.

A riveting part for movably connecting a main plate body and a bracket body, wherein the riveting part is integrally formed on the main plate body or the bracket body through stretching and passes through a circle center of the bracket connecting part or the main plate connecting part. The existing riveting parts are all rivets. The rivets are used for connecting the main plate body to the bracket body, and then spray-coating, electroplating or paint baking is performed on the entire body.

In case of spray-coating and paint baking, spray-coating is powder spray-coating. In case of locking by using rivets, there is a gap between contact surfaces of the cap and the main plate body, and the powder cannot fully enter the contact surfaces from the gap to fully spray-coat this portion. In addition, some powder will accumulate around the cap on the main plate body, which leads to uneven spray-coating and affects the surface attractiveness of the supporting frame.

In case of electroplating, rivet locking causes a gap between the contact surfaces of the cap and the main plate body. Due to the iron nature of the rivets in the electroplating process, there may be residual electroplating solution on the rivets after electroplating, resulting in rust and affecting the overall attractiveness of the supporting frame.

However, the riveting part in the present invention is integrally formed with the main plate body or the bracket body, thus in addition to not needing to use additional rivets during the assembly of the supporting frame, effectively reducing the production cost of the enterprise, ensuring the overall attractiveness of the supporting frame during subsequent spray-coating, electroplating or paint baking, and avoiding the situation of rusting.

Further, the riveting part protrudes from a surface of the main plate body or the bracket body, and when the main plate body and the bracket body are assembled, the riveting part passes through the corresponding bracket connecting part or main plate connecting part and is riveted, so that the main plate body and the bracket body are riveted together. In the assembly process, there is no need to use additional rivets to connect the main plate body and the bracket body, thus effectively reducing the production cost of the enterprise.

Further, tops of two ends of the length direction of the main plate body are respectively provided with a clamping groove for the bracket body to be rotatably clamped in. When the bracket body is horizontally placed, the supporting part can play a certain role of supporting the bracket body, thus making the placement of the bracket body more stable during use.

The present invention has the following beneficial effects:
1. In the present invention, the main plate body and the bracket body are assembled before surface treatment, and the outer edges of the main plate connecting part and the bracket connecting part are semicircular structures having the same diameter, so that after one time of surface treatment, all visible surfaces of the assembled supporting frame can be uniformly treated by the surface treatment agent, thus effectively improving the efficiency of the surface treatment of the supporting frame and reducing the production cost of the enterprise.
2. In the present invention, in a case that the main plate connecting part and the bracket connecting part are respectively mounted on the main plate body and the bracket body, they are connected through a connecting shaft passing through the centers of the two, thus achieving the foldable connection of the main plate body and the bracket body. At the same time, when the main plate body and the bracket body are subjected to spray-coating, electroplating or paint baking as a whole, the semicircular structures of the main plate connecting part and the bracket connecting part can also ensure that one time of surface treatment can completely distribute the surface treatment agent on all visible surfaces in the rotation process of the main plate connecting part and the bracket connecting part, thus effectively improving the processing efficiency of the supporting frame.
3. In the present invention, by providing the integrally formed riveting part on the surface of the main plate body or the bracket body, when connecting the main plate body and the bracket body, there is no need to use additional screws to connect the main plate connecting part and the bracket connecting part. After the riveting part passes through the main plate connecting part and the bracket connecting part, it can rivet the main plate connecting part and the bracket connecting part, thus effectively reducing the production cost of the enterprise.
4. In the present invention, the main plate connecting part, the bracket connecting part, the main plate body, the bracket body, the riveting part, the positioning protrusion, and the positioning groove cooperate with each other. When the bracket body rotates to the angle of surface treatment, the positioning protrusion can be clamped in the corresponding positioning groove to prevent relative rotation between the bracket body and the main plate body in the surface treatment process from influencing the effect of surface treatment. Providing the main plate connecting part and the bracket connecting part can ensure that the visible surfaces of the assembled main plate body and bracket body in all states can be treated in one time, thus effectively improving the processing efficiency of the supporting frame.

### Description of the Drawings

FIG. 1 illustrates an overall structural top view of a connecting structure of a supporting frame according to an embodiment.
FIG. 2 illustrates an overall structural isometric view of a supporting frame according to an embodiment.
FIG. 3 illustrates an overall structural isometric view of a supporting frame at another angle of view according to an embodiment.
FIG. 4 illustrates a structural schematic diagram of a positioning protrusion provided on a bracket body of a supporting frame according to an embodiment.
FIG. 5 illustrates a partial structural schematic diagram of a positioning groove provided in a main plate body of a supporting frame according to an embodiment.
FIG. 6 illustrates a partial structural schematic diagram of a bracket body of a supporting frame according to an embodiment.
FIG. 7 illustrates another partial structural schematic diagram of a bracket body of a supporting frame according to an embodiment.
FIG. 8 illustrates another overall structural isometric view of a supporting frame according to an embodiment.
FIG. 9 illustrates yet another overall structural isometric view of a supporting frame according to an embodiment.
FIG. 10 illustrates a schematic diagram of a rotation trajectory of a first point A and a second point B of a first connecting part after rotation in the existing technology.
FIG. 11 illustrates a structural schematic diagram of a bracket body of a supporting frame in a rotating state according to an embodiment.
FIG. 12 illustrates a structural schematic diagram of a clamping protrusion and a clamping groove of a supporting frame after clamping according to an embodiment.

1-main plate body; 11-riveting part; 12-main plate connecting part; 13-groove; 14-clamping groove; 2-bracket body; 21-mounting part; 22-supporting part; 23-bracket connecting part; 24-hook; 4-positioning groove; 5-positioning protrusion; 6-fastening structure; 7-connecting shaft; 8-hinging part; 9-connection bearing part; 10-clamping protrusion; 15-clamping groove.

### Detailed Description of the Embodiments

The exemplary embodiments of the present invention will be described below in detail with reference to the drawings, in order to make the advantages and features of the present invention more easily understood by those skilled in the art, and thus to clearly define the scope of protection of the present invention.

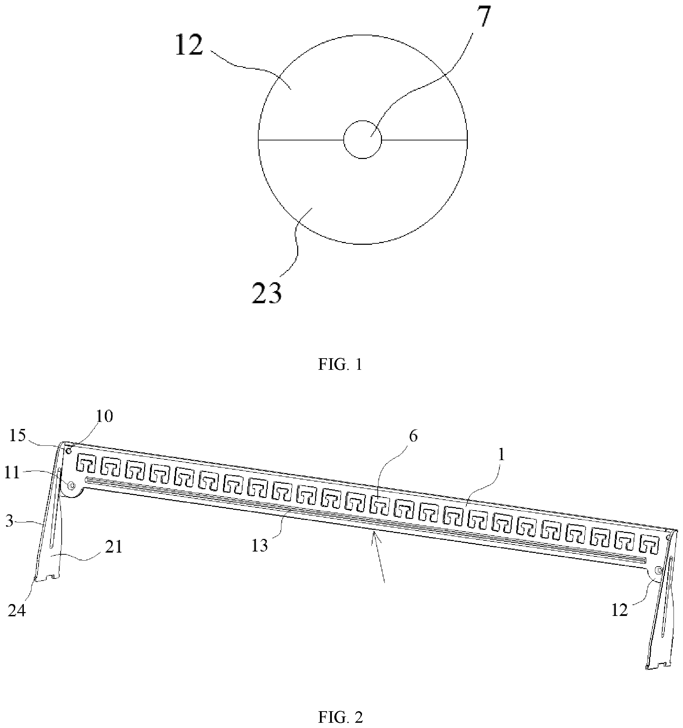

Referring to FIG. 1 to FIG. 12, the present invention provides a method for surface treatment of a supporting frame. The supporting frame includes a main plate body 1 and a bracket body 2 which are rotatably connected. The main plate body 1 is assembled with the bracket body 2. The main plate body 1 and the bracket body 2 are respectively provided with a main plate connecting part 12 and a bracket connecting part 23. Here, the assembly of the main plate body 1 and the bracket body 2 may be pre-rotation or full mounting.

Surface treatment is performed on the assembled supporting frame. An included angle between the main plate body 1 and the bracket body 2 during surface treatment is a first included angle.

After treatment, when the bracket body rotates around the main plate body to a second included angle, a surface treatment agent is distributed in any area of working surfaces of the main plate connecting part 12 and the bracket connecting part 23. The first included angle is different from the second included angle.

Before surface treatment, the included angle between the main plate body 1 and the bracket body 2 is the first included angle, which may be any angle. In the existing technology, due to the mutual obstruction between the outer working surfaces of the main plate body 1 and the bracket body 2, it is impossible to achieve uniform surface treatment of all positions exposed at any angle after assembly in all areas of the outer surfaces of the main plate body 1 and the bracket body 2 through one time of surface treatment, that is, to achieve surface treatment of all visible surfaces of the supporting frame at any angle of rotation of the bracket body 2. Therefore, it is usually necessary to firstly treat the surfaces of the main plate body 1 and the bracket body 2 respectively before assembly, but the assembly process inevitably causes certain scratches on the surfaces of the two. However, In the present invention, the main plate body 1 and the bracket body 2 are firstly assembled, and then overall surface treatment is performed. In addition, in the present invention, the outer edges of the main plate connecting part 12 and the bracket connecting part 23 are semicircular structures, so that after one time of surface treatment on the assembled supporting frame, all visible surfaces of the assembled supporting frame can be uniformly treated by the surface treatment agent, thus effectively improving the efficiency of the surface treatment of the supporting frame, reducing the production cost of the enterprise, and avoiding the situation of causing damage to the surfaces of the main plate body 1 and the bracket body 2.

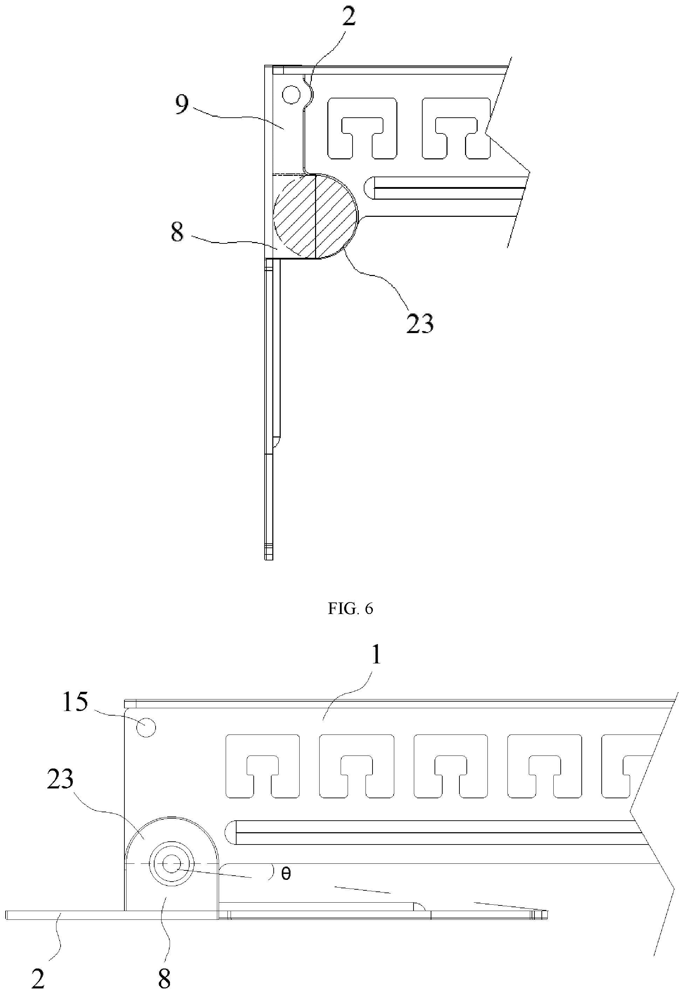

It should be noted that the "outer working surface" here refers to any side surface of the supporting frame in a working state. The area where the main plate connecting part 12 and the bracket connecting part 23 are obstructed or covered by each other is not considered the "outer working surface". Referring to FIG. 6, the shaded portion is the "outer working surface".

The surface treatment of the supporting frame may be spray-coating, electroplating, or paint baking. In a case that a spray-coating surface treatment method is adopted, the surface treatment agent is coating liquid or powder. In a case that an electroplating surface treatment method is adopted, the surface treatment agent is electroplating solution. It includes, but not limited to, the three methods, i.e., spray-coating, electroplating, and paint baking mentioned above, as long as it can distribute the surface treatment agent onto the surface of the supporting frame. In case of spray-coating, powder spray-coating may be adopted. In case of electroplating, the supporting frame may be placed in an electroplating tank containing electroplating solution. It should be noted that the present invention is not limited to be applicable to spray-coating, electroplating, and paint baking, but it is also applicable to other surface treatment methods such as sandblasting and painting.

Referring to FIG. 1 to FIG. 9, provided is a connecting structure for achieving rotatable connection between a first part and a second part. The first part is provided with a first connecting part.

The second part is provided with a second connecting part.

A circle where a movement trajectory of each point on an edge of the first connecting part is located is the same circle and is a first circle.

A circle where a movement trajectory of each point on an edge of the second connecting part is located is the same circle and is a second circle.

The first circle and the second circle are concentrically arranged.

Therefore, in the present invention, by keeping the movement trajectory of each point on the edge of the first connecting part to be on the edge line of the same circle, i.e., the first circle, and keeping the movement trajectory of each point on the edge of the second connecting part to be on the edge line of the same circle, i.e., the second circle, it is ensured that the first connecting part and the second connecting part will never obstruct each other when the first part and the second part rotate. Therefore, it can achieve spray-coating or electroplating of the first part and the second part after assembly, and can achieve the effect of dead-corner-free spray-coating or electroplating.

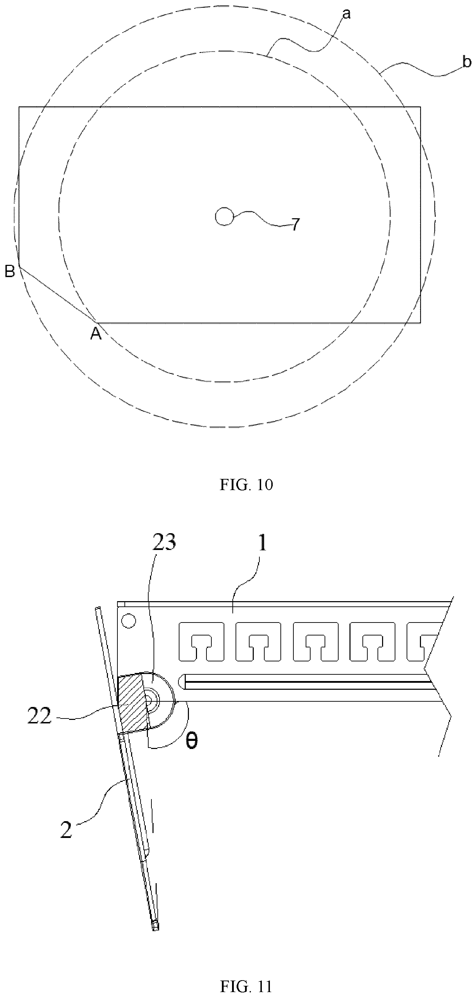

Therefore, there is no need to avoid blind areas of spray-coating or electroplating caused by mutual obstruction between the first part and the second part. For example, taking FIG. 10 as an example, the circle where the first point A on the edge of the first connecting part rotates with the first connecting part is circle a, and the circle where the first point B on the edge of the first connecting part rotates with the first connecting part is circle b. Since the diameters of circle a and circle b are different, the overlapping area between the first connecting part and the second connecting part is different when the first point A is in different positions. Therefore, there are always areas on the first part and the second part that cannot be fully spray-coated or electroplated.

The main plate connecting part 12 and the bracket connecting part 23 are concentrically arranged, and outer edges of the main plate connecting part 12 and the bracket connecting part 23 are both semicircular. Two concentrically arranged semicircles allow the bracket body 2 to rotate freely around the riveting part 11 as the circle center, so that the surface treatment agent is distributed on all visible surfaces of the bracket body 2 and the main plate body 1.

In the subsequent surface treatment of the main plate body 1 and the bracket body 2 as a whole, it can be ensured that one time of surface treatment can completely distribute the surface treatment agent on all visible surfaces of the supporting frame in the rotation process of the main plate connecting part 12 and the bracket connecting part 23, thus effectively improving the processing efficiency of the supporting frame, so that there is no need to repeatedly adjust the angle of the bracket body 2 for surface treatment. Moreover, completion in one time can also make the surface treatment of the supporting frame more uniform, and ensure the processing quality.

It should be noted that it is not limited that the outer edges of the first connecting part and the second connecting part are only semicircular, but they may also be completely circular, as long as the first connecting part and the second connecting part can always cover each other during rotation around the same center, so that there will be no areas on the surfaces of the first part and the second part that cannot be completely treated in the subsequent surface treatment process.

Referring to FIG. 1 to FIG. 3, provided is a supporting frame. The first part is a main plate body 1. The second part is a bracket body 2. The first connecting part is a main plate connecting part 12. The second connecting part is a bracket connecting part 23. The main plate body 1 and the bracket body 2 are rotatably connected. The main plate body 1 and the bracket body 2 are rotatably connected, thus achieving the foldability of the main plate body 1 and the bracket body 2, so that when the supporting frame is not in use, the bracket body 2 can be folded on the side of the main plate body 1, thus effectively reducing nearly 50%of the space occupied during packaging, and reducing the packaging and transportation cost of the enterprise.

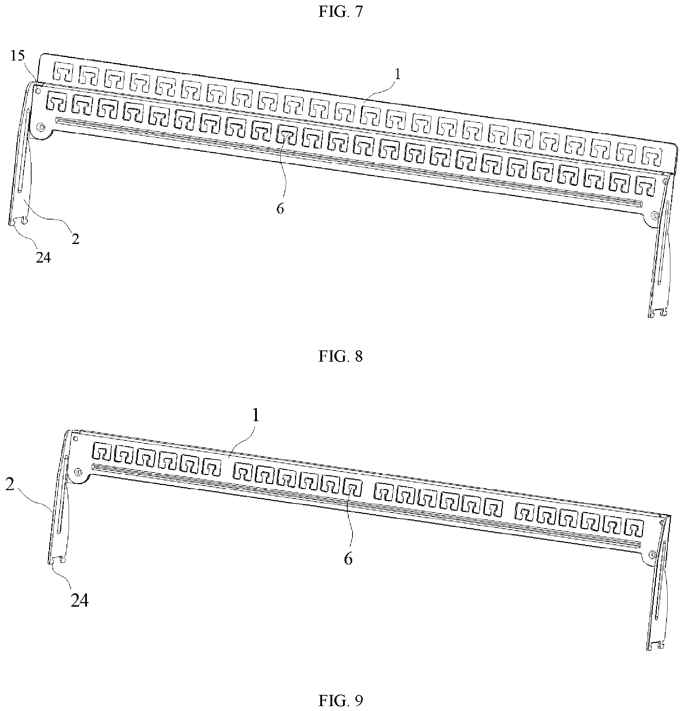

Referring to FIG. 6 and FIG. 7, the bracket connecting part 23 is fixedly connected to a side of the bracket body 2 through a supporting part 22. A horizontal plane on the bracket connecting part is connected to the supporting part 22. A plane where the bracket connecting part 23 is located is perpendicular to a plane where the bracket body 2 is located. In combination with the figures, it can be seen that the supporting part 22 and the bracket connecting part 23 are divided into two portions through the diameter of the bracket connecting part 23.

In some embodiments, referring to FIG. 6, the supporting part 22 includes a hinging part 8 and a connection bearing part 9. The bracket connecting part 23 is connected to the bracket body 2 through the hinging part 8. The connection bearing part 9 is provided on a side of the hinging part 8 and a bottom surface thereof is connected to the bracket connecting part 23. A plane where the supporting part 22 is located is perpendicular to a plane where the bracket body 2 is located. When the bracket body 2 rotates to its side and presses against the main plate body 1, one end of the connection bearing part 9 is clamped in a clamping groove 14, thus providing a certain role of supporting the main plate body 1 during the working of the supporting frame, and making the supporting frame more stable during use.

It should be noted that the size of the connection bearing part 9 is not limited, as long as it is ensured that during the subsequent rotation, positioning, spray-coating, electroplating or paint baking of the bracket body 2, it will not affect the overall one-time surface treatment of the visible surfaces of the supporting frame.

In other embodiments, the supporting part 22 includes a hinging part 8. The bracket connecting part 23 is connected to the bracket body 2 through the hinging part 8. A plane where the hinging part 8 is located is perpendicular to a plane where the bracket body 2 is located. The hinging part 8 is a square with a length equal to the diameter of the bracket connecting part 23 and a height greater than or equal to the radius of the bracket connecting part 23. In this embodiment, during the subsequent surface treatment of the supporting frame, at any angle within the rotatable range of the bracket body 2, no interference will be caused to the surface treatment effect. In this case, the positions and number of positioning protrusions 5 and positioning grooves 4 around the circle center of the bracket connecting part 23 or the main plate connecting part 12 may be freely set.

In other embodiments, referring to FIG. 7 and FIG. 11, the supporting part 22 includes a hinging part 8. The side of the hinging part 8 is not provided with a connection bearing part 9. The shapes of the hinging parts 8 in FIG. 7 and FIG. 11 are different. The shape in FIG. 11 is not a complete rectangle. In a case that the hinging part 8 is configured to have the shape in FIG. 7, the angle at which the bracket body 2 can rotate without affecting the complete surface treatment of the visible surfaces of the supporting frame is θ represented in the figure, that is, providing differently-shaped hinging parts 8 can enable the bracket body 2 to get different rotation ranges.

It should be noted that, referring to FIG. 7, the rotation angle θ of the bracket body 2 refers to an angle formed by taking the riveting part 11 as the vertex, taking a connecting line between the riveting part 11 and the hooks 24 on the bracket body 2 as one side, and taking a projection line that connects the riveting part 11 where the bottom surface of the main plate body 1 is located as the other side.

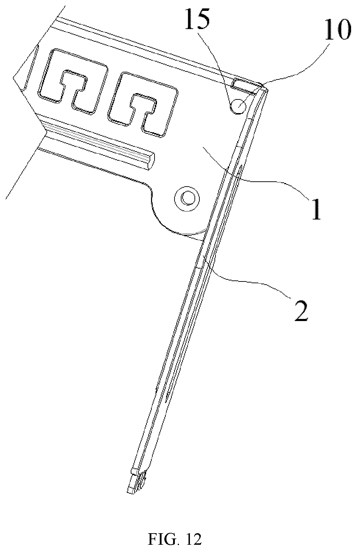

Referring to FIG. 12, the supporting part 22 is provided with a clamping protrusion 10 protruding from a surface of the supporting part in a direction towards the main plate body 1. The main plate body 1 is provided with a clamping groove 15 for the clamping protrusion 10 to be clamped in when the bracket body 2 presses against the side of the main plate body 1. By providing the corresponding clamping protrusion 10 and clamping groove 15, the bracket body 2 is not easily collapsed when the supporting frame is in a working state, thus ensuring the stability of cables hung on the supporting frame in the working state. It should be noted that it is not limited that the clamping protrusion 10 and the clamping groove 15 can only be provided separately on the supporting part 22 and the main plate body 1. In a case that the clamping groove 15 is provided in the main plate body 1, providing the clamping protrusion 10 on the supporting part 22 can also achieve the same effect.

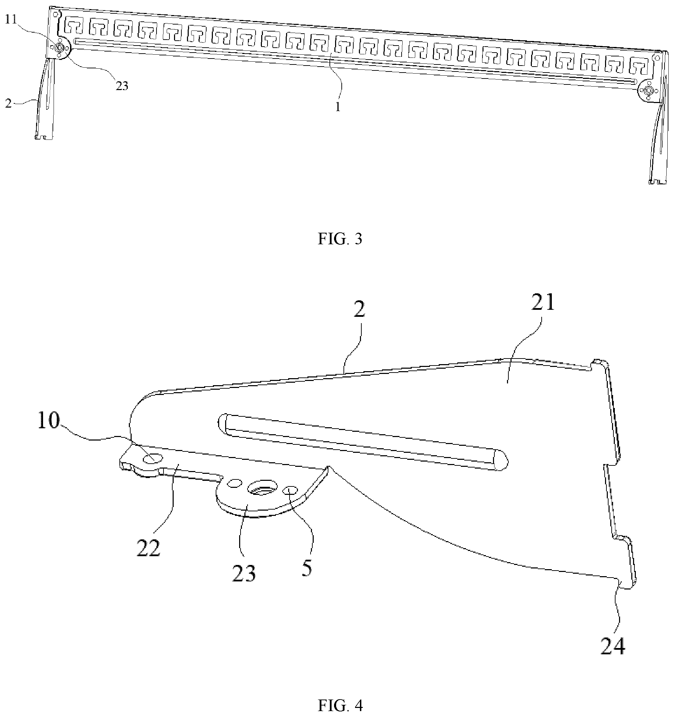

The main plate connecting part 12 is located on lower surfaces of two ends of a length direction of the main plate body 1, and extends towards an outer side of the main plate body 1. Therefore, the hinging between the main plate connecting part 12 and the bracket connecting part 23 is facilitated, so that the bracket body 2 can rotate around the hinging point to press against the lower surface or side of the main plate body 1. It should be noted that it is not limited that the main plate connecting part 12 can only be provided on the lower surfaces of the ends of the main plate body 1. In a case that it is provided on the side of the main plate body 1, the effect in the present invention can also be achieved. Referring to FIG. 3, the lower surface of the main plate body 1 in the present invention is illustrated by an arrow in the figure.

One of two surfaces of the main plate body 1 in contact with the bracket body 2 is provided with at least one positioning protrusion 5, and the other is provided with at least one positioning groove 4 for the positioning protrusion 5 to be clamped in. By providing the positioning protrusion 5 and the positioning groove 4, an effect of positioning the rotation of the bracket body 2 on the main plate body 1 is achieved. The positioning protrusion 5 and the positioning groove 4 are both provided around the circle center, so that the positioning of the bracket body 2 is more stable when it rotates to the spray-coating or electroplating position or when it rotates to the position where the supporting frame is in a use state. It should be noted that the use state of the supporting frame here refers to a state that the bracket body 2 rotates to its side and presses against the side of the main plate body 1.

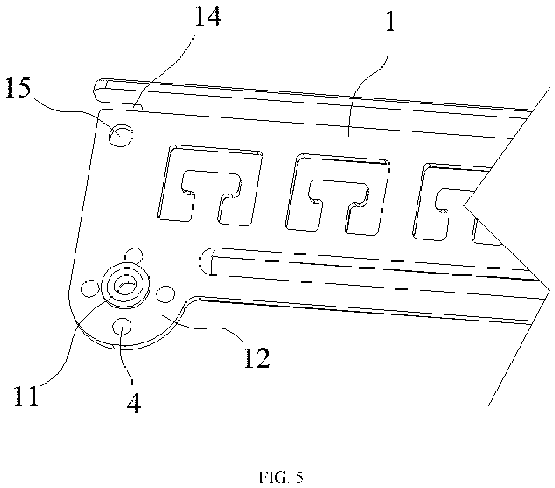

Referring to FIG. 4 and FIG. 5, in some embodiments, the main plate body 1 is provided with four positioning grooves 13, and the bracket body 2 is provided with two positioning protrusions 5. One of the two positioning protrusions 5 is used for positioning the bracket body 2 when the bracket body 2 rotates to its side and presses against the side of the main plate body 1, so as to ensure the stability of the entire supporting frame in use. The other positioning protrusion is used for positioning during subsequent surface treatment when the bracket body 2 rotates to a designated surface treatment position, so as to avoid displacement of the bracket body 2 in the surface treatment process, which may affect the overall effect of the surface treatment.

The two positioning protrusions 5 are circumferentially provided in an array around the circle center of the bracket connecting part 23. In addition, the two positioning protrusions 5 are specifically located on the diameter of the bracket connecting part 23. The four positioning grooves 13 in the main plate body 1 are circumferentially provided in an array around the circle center of the main plate connecting part 12, of which two positioning grooves 13 are provided on the diameter of the main plate connecting part 12, and the other two positioning grooves 13 are provided on the symmetry axis of the main plate connecting part 12. During surface treatment, the bracket body 2 rotates to the two positioning protrusions 5 thereon, which are clamped in the positioning grooves 4 horizontally provided in the main plate body 1. In this case, a straight line where the length direction of the bracket body 2 is located is parallel to a straight line where the length direction of the main plate body 1 is located, so that the best effect can be achieved during subsequent surface treatment.

In other embodiments, the number of the positioning protrusions 5 on the bracket body 2 may be set to one, and the number of the positioning grooves 4 in the main plate body 1 may be correspondingly set to two, which can also achieve the positioning of the bracket body 2 during surface treatment and in the use state. Of course, the one positioning protrusion 5 here may also be provided on the main plate body 1, and correspondingly, the bracket body 2 is provided with two corresponding positioning grooves 4.

It should be noted that the specific positions of the positioning protrusion 5 and the positioning groove 13 are not limited, as long as the arrangement of the positioning protrusion 5 and the positioning groove 13 meets the requirement of the overall surface treatment of the supporting frame. In addition, the position of the positioning protrusion 5 is shallow, so that there will be no interference in the rotation process of the bracket body 2.

Referring to FIG. 2 and FIG. 8, the bracket body 2 further includes a mounting part 21. One end of the mounting part 21 away from the supporting part 22 is provided with hooks 24. The hooks 24 may be provided at two ends of a bottom of the mounting part 21 in opposite directions, or may be provided at the bottom of the mounting part 21 in the same direction. The arrangement of the hooks 24 may be changed according to the structure of the distribution frame on which the supporting frame is assembled, so that the supporting frame can be mounted on the distribution frame through the hooks 24.

The main plate body 1 is provided with a plurality of fastening structures 6 for mounting cable ties along a length direction of the main plate body. Each fastening structure 6 includes a network cable slot and a T-shaped clamping hook. The T-shaped clamping hook facilitates the clamping of the cable tie, thus improving the convenience in use. When no cable tie is used, the network cable slot can also play a role of storing the network cable. The network cable slot is an E-shaped slot provided in an E-shape. Of course, the network cable slot here is not limited to an E-shaped slot, as long as it can accommodate the insertion and storage of the network cable.

It should be noted that the size and layout of the fastening structures 6 are not limited, as long as they can meet the quantity and size requirements of network cables.

A side of the main plate body 1 away from a riveting part is provided with at least one groove 13 along a length direction of the main plate body. The depth of the groove 13 is greater than the thickness of the main plate body 1. By providing the groove 13, the overall stress strength of the supporting frame can be enhanced, and the service life of the supporting frame can be improved.

The diameter of the main plate connecting part 12 is equivalent to the diameter of the bracket connecting part 23. The bracket body 2 is connected to the main plate body 1 through the connecting structure. Only when the diameter of the main plate connecting part 12 and the bracket connecting part 23 is the same, can all visible surfaces of the main plate body 1 and the bracket body 2 be treated in one time, so that all visible surfaces are distributed with the surface treatment agent.

Referring to FIG. 2 to FIG. 3, tops of two ends of the length direction of the main plate body 1 are respectively provided with a clamping groove 14 for the bracket body 2 to be rotatably clamped in. In some embodiments, the supporting part 22 on the bracket body 2 is perpendicular to the mounting part 21. When the supporting frame is in use, the bracket body 2 rotates to its side and presses against the main plate body 1. The supporting part 22 is located behind the main plate body 1. When the bracket body 2 is horizontally placed, the supporting part 22 can play a certain role of supporting the bracket body, thus making the placement of the bracket body 2 more stable during use.

Provided is a riveting part for movably connecting a main plate body 1 and a bracket body 2. The riveting part 11 is integrally formed on the main plate body 1 or the bracket body 2 through stretching and passes through a circle center of the bracket connecting part 23 or the main plate connecting part 12. The existing riveting parts 11 are all rivets. The rivets are used for connecting the main plate body 1 to the bracket body 2, and then spray-coating, electroplating or paint baking is performed on the entire body.

It should be noted that the shape of the integrally formed riveting part includes, but not limited to, cylindrical shape or other shapes, as long as it can achieve the final riveting of the main plate body 1 and the bracket body 2.

In case of spray-coating and paint baking, spray-coating is powder spray-coating. In case of locking by using rivets, there is a gap between contact surfaces of the cap and the main plate body 1, and the powder cannot fully enter the contact surfaces from the gap to fully spray-coat this portion. In addition, some powder will accumulate around the cap on the main plate body, which leads to uneven spray-coating and affects the surface attractiveness of the supporting frame.

In case of electroplating, rivet locking causes a gap between the contact surfaces of the cap and the main plate body 1. Due to the iron nature of the rivets in the electroplating process, there may be residual electroplating solution on the rivets after electroplating, resulting in rust and affecting the overall attractiveness of the supporting frame.

However, the riveting part 11 in the present invention is integrally formed with the main plate body 1 or the bracket body 2, thus in addition to not needing to use additional rivets during the assembly of the supporting frame, effectively reducing the production cost of the enterprise, ensuring the overall attractiveness of the supporting frame during subsequent spray-coating, electroplating or paint baking, and avoiding the situation of rusting.

The riveting part 11 protrudes from a surface of the main plate body 1 or the bracket body 2. When the main plate body 1 and the bracket body 2 are assembled, the riveting part 11 passes through the corresponding bracket connecting part 23 or main plate connecting part 12 and is riveted, so that the main plate body 1 and the bracket body 2 are riveted together. In the assembly process, there is no need to use additional rivets to connect the main plate body 1 and the bracket body 2, thus effectively reducing the production cost of the enterprise.

In some embodiments, the riveting part 11 is integrally formed on the main plate body 1 and passes through the circle center of the main plate connecting part 12 connected to the main plate body 1. When the main plate body 1 is connected to the bracket body 2, the riveting part 11 on the main plate body 1 also passes through the circle center of the bracket connecting part 23, and then the main plate body 1 is riveted to the bracket body 2 through riveting. In the assembly process, there is no need to use additional rivets to connect the main plate body 1 and the bracket body 2, thus effectively reducing the production cost of the enterprise.

It should be noted that the riveting part 11 may also be integrally formed on the bracket body 2, and pass through the circle center of the bracket connecting part 23. When the main plate body 1 is connected, it is acceptable as long as the riveting part 11 passes through the circle center of the main plate connecting part 12 on the main plate body 1, and it is not limited that it must be provided on the main plate body 1.

In some embodiments, after the supporting frame is assembled, the supporting frame is vertically lifted by using a fixture. This lifting method can reduce the space occupied in the bracket surface treatment process, so that the surface treatment of multiple supporting frames can be performed simultaneously, thus effectively improving the processing efficiency of the supporting frame. After lifting, the bracket bodies 2 at two ends of the supporting frame are rotated, so that the positioning protrusions 5 on the supporting frame are clamped in the corresponding positioning grooves 4, thus positioning the positions of the bracket bodies 2 during surface treatment. After positioning, the lifted supporting frames are put into a spray-coating device or an electroplating tank for spray-coating or electroplating.

When the position of the bracket body 2 is adjusted, the rotation process takes the riveting part 11 as the circle center. The arrangement of the positioning protrusion 5 and the positioning groove 4 is to ensure that the position of the bracket body 2 relative to the main plate body 1 does not change during subsequent surface treatment of the supporting frame, and ensure that bracket body 2 does not obstruct the visible surfaces of the main plate body 1, thus ensuring that the surface treatment of the supporting frame is completed in one time and ensuring the processing efficiency of the supporting frame.

It should be noted that the positions and number of the positioning protrusions 5 and positioning grooves 4 on the supporting frame are not limited, as long as the positioning of the bracket body 2 can be achieved and the spray-coating or electroplating effect is not affected.

The main plate body 1 is provided with four positioning grooves 13, and the bracket body 2 is provided with two positioning protrusions 5. One of the two positioning protrusions 5 is used for positioning the bracket body 2 when the bracket body 2 rotates to its side and presses against the side of the main plate body 1. In the surface treatment process, the supporting frame is always in a folded state. It should be noted that in the working state, the bracket body 2 is perpendicular to the main plate body 1, and the folded state is the relative position relationship except the perpendicular relationship.

The fixture used in this example is a lifting hook, which passes through the E-shaped groove in the fastening structure during lifting. The E-shaped groove that the lifting hook passes through is the topmost E-shaped groove close to the bracket body, and the length of the line connecting the contact point on the lifting hook with the E-shaped groove is about 0.8mm. That is, the contact surface between the lifting hook and the E-shaped groove is small enough that the obstruction influence caused in the spray-coating or electroplating process can be ignored and will not affect the overall spray-coating or electroplating effect of the supporting frame.

This method can achieve the best spray-coating, electroplating, or paint baking effect of the supporting frame. It should be noted that the structure of the fixture for gripping the supporting frame in this method is not the subject of protection of the present invention, as long as it can meet the requirement that it will not affect subsequent spray-coating and electroplating in the lifting process of the supporting frame. Therefore, the specific structure will not be elaborated here.

The above embodiments are only intended to describe the technical concept and characteristics of the present invention, are for the purpose of allowing those skilled in the art to understand the content of the present invention and implement it, and cannot be understood as limiting the scope of protection of the present invention. Any equivalent changes or modifications made according to the essence of the present invention should be included within the scope of protection of the present invention.

## Claims

1. A method for surface treatment of a supporting frame, the supporting frame comprising a main plate body and a bracket body which are rotatably connected, the main plate body and the bracket body being connected through a connecting structure, wherein the method comprises: assembling the main plate body with the bracket body, the main plate body and the bracket body being respectively provided with a main plate connecting part and a bracket connecting part;
performing surface treatment on the assembled supporting frame, an included angle between the main plate body and the bracket body during surface treatment being a first included angle,
after treatment, when the bracket body rotates around the main plate body to a second included angle, a surface treatment agent being distributed in any area of working surfaces of the main plate connecting part and the bracket connecting part, the first included angle being different from the second included angle.

2. The method for the surface treatment of the supporting frame according to claim 1, wherein the surface treatment of the supporting frame is spray-coating, electroplating, or paint baking.

3. A connecting structure for achieving rotatable connection between a first part and a second part, wherein the first part is provided with a first connecting part,
the second part is provided with a second connecting part,
a circle where a movement trajectory of each point on an edge of the first connecting part is located is the same circle and is a first circle,
a circle where a movement trajectory of each point on an edge of the second connecting part is located is the same circle and is a second circle, and
the first circle and the second circle are concentrically arranged.

4. The method for the surface treatment of the supporting frame according to claim 3, wherein the main plate connecting part and the bracket connecting part are concentrically arranged, and outer edges of the main plate connecting part and the bracket connecting part are both semicircular.

5. A supporting frame comprising the connecting structure according to any one of claims 3-4, wherein the first part is a main plate body, the second part is a bracket body, the first connecting part is a main plate connecting part, the second connecting part is a bracket connecting part, and the main plate body and the bracket body are rotatably connected.

6. The supporting frame according to claim 5, wherein the bracket connecting part is fixedly connected to a side of the bracket body through a supporting part, a horizontal plane on the bracket connecting part is connected to the supporting part, and a plane where the bracket connecting part is located is perpendicular to a plane where the bracket body is located.

7. The supporting frame according to claim 5, wherein the supporting part is provided with a clamping protrusion protruding from a surface of the supporting part in a direction towards the main plate body, and the main plate body is provided with a clamping groove for the clamping protrusion to be clamped in when the bracket body presses against the side of the main plate body.

8. The supporting frame according to claim 5, wherein the main plate connecting part is located on lower surfaces of two ends of a length direction of the main plate body, and extends towards an outer side of the main plate body.

9. The supporting frame according to claim 5, wherein one of two surfaces of the main plate body in contact with the bracket body is provided with at least one positioning protrusion, and the other is provided with at least one positioning groove for the positioning protrusion to be clamped in.

10. The supporting frame according to claim 5, wherein the bracket body further comprises a mounting part, one end of the mounting part away from the supporting part is provided with hooks, and the main plate body is provided with a plurality of fastening structures for mounting cable ties along a length direction of the main plate body.

11. The supporting frame according to claim 5, wherein a side of the main plate body away from a riveting part is provided with at least one groove along a length direction of the main plate body, and the depth of the groove is greater than the thickness of the main plate body.

12. The supporting frame according to claim 5, wherein the diameter of the main plate connecting part is equivalent to the diameter of the bracket connecting part.

13. A riveting part for movably connecting a main plate body and a bracket body, wherein the riveting part is integrally formed on the main plate body or the bracket body through stretching and passes through a circle center of the bracket connecting part or the main plate connecting part.

14. The riveting part according to claim 13, wherein the riveting part protrudes from a surface of the main plate body or the bracket body, and when the main plate body and the bracket body are assembled, the riveting part passes through the corresponding bracket connecting part or main plate connecting part and is riveted, so that the main plate body and the bracket body are riveted together.
